# EUROPÄISCHE PATENTANMELDUNG

(11) **EP 2 709 151 A1**
(43) Veröffentlichungstag der Anmeldung: **19.03.2014**
(21) Anmeldenummer: 13184804.6
(22) Anmeldetag: 17.09.2013
(51) Int. Cl.: H01L 23/31, H01L 21/56, H01L 23/29

(54) **Elektronische Baugruppe mit einem räumlichen spritzgegossenen elektronischen Schaltungsträger**

(30) Priorität: 18.09.2012 DE 102012108770
(71) Anmelder: Heicks, Rudolf, 59590 Geseke (DE)
(72) Erfinder: Heicks, Rudolf, 59590 Geseke (DE)
(74) Vertreter: Graefe, Jörg

(57) **Zusammenfassung**

Die Erfindung betrifft eine elektronische Baugruppe mit einem räumlichen spritzgegossenen elektronischen Schaltungsträger (5) auf dem elektrische und/oder elektronische Bauelemente (1 , 2, 4) angeordnet sind, wobei die Baugruppe eine Parylenebeschichtung (6) aufweist.

## Beschreibung

Die vorliegende Erfindung betrifft eine elektronische Baugruppe mit einem räumlichen spritzgegossenen Schaltungsträger (3D-MID) auf dem elektrische und/oder elektronische Bauelemente angeordnet sind.

Elektronische Baugruppen mit einem räumlichen spritzgegossenen Schaltungsträger sind aus dem Stand der Technik bekannt, insbesondere unter der englischen Abkürzung 3D-MID, die für *three-dimensional molded interconnected device* steht. Die elektronischen Bauelemente sind an dem spritzgegossenen Schaltungsträger aus Kunststoff, Metall oder anderen Materialien angebracht und metallische Leiterbahnen sind darauf aufgetragen. Für die Herstellung derartiger Baugruppen sind eine Reihe verschiedener Verfahren bekannt.

Wesentliche Einsatzgebiete für derartige Baugruppen sind die Kraftfahrzeugelektronik, die Automatisierungstechnik, die Medizintechnik, die Hausgerätetechnik, die Telekommunikationstechnik, die Mess- und Analysetechnik sowie die Luft- und Raumfahrt.

Die räumlichen spritzgegossenen Schaltungsträger weisen im Gegensatz zu den verbreiteten planaren einfach oder mehrfach kaschierten Schaltungsträgern oder Leiterplatten gekrümmte oder abgewinkelte Flächen auf, die im Grunde beliebig geformt sein können. Dieser hohe Grad an Gestaltungsfreiheit ermöglicht die Integration von elektrischen und mechanischen Funktionen in ein Spritzgussteil. Das kann zu einer Miniaturisierung der Baugruppe und zur Einsparung von Bauteilen führen. Die Herstellung von elektronischen Baugruppen kann dadurch verkürzt werden. Außerdem werden durch die 3D-MID-Technologie bestimmte Baugruppenformen erst möglich.

Sind elektronische Baugruppen für einen Einsatz in einer rauen Umgebung vorgesehen, werden die Schaltungsträger und die darauf montierten Bauelemente und die Leiterbahnen beschichtet. Es ist bekannt die Baugruppen dazu zu lackieren.

Das Lackieren von dreidimensionalen Strukturen wie Baugruppen mit einem räumlichen spritzgegossenen Schaltungsträger ist allerdings immer mit dem Problem verbunden, dass der Lack verläuft und sich Stellen mit viel Lacküberdeckung, mit wenig Lacküberdeckung und mit keiner Lacküberdeckung ausbilden, was nur durch Kontrollen und Nacharbeiten vermieden werden kann, was sehr aufwendig ist. Insbesondere das Eindringen von Lack in Spalten und Ritzen zwischen Bauelementen oder zwischen Bauelementen und Schaltungsträgern ist nicht immer sichergestellt.

Der Erfindung lag somit das Problem zugrunde, eine verbesserte Baugruppe mit einer Beschichtung und ein verbessertes Verfahren zum Beschichten einer Baugruppe vorzuschlagen.

Die Aufgabe im Hinblick auf die Baugruppe wird dadurch gelöst, dass die Baugruppe eine Parylenebeschichtung aufweist.

Die erfindungsgemäße Baugruppe kann Kontaktelemente aufweisen, mit welcher eine durch die Bauelemente und Leiterbahnen gebildete Schaltung von außen kontaktierbar ist. Diese Kontaktelemente können zumindest teilweise frei von der Parylenebeschichtung sein.

Die Parylenebeschichtung kann aus Parylene des Typs C, D, N, F, HT oder AF bestehen.

Die Parylenebeschichtung kann den Schaltungsträger, die Leiterbahnen und die Bauelemente mit Ausnahme der von außen kontaktierbaren Kontaktelemente ganz oder teilweise abdecken. Die Parylenebeschichtung einer erfindungsgemäßen Baugruppe kann ganz oder teilweise in Spalten oder Ritzen zwischen Bauelementen, zwischen Bauelementen und Schaltungsträger bzw. zwischen Bauelementen und Leiterbahnen eingedrungen sein.

Im Hinblick auf das Verfahren wird die Aufgabe dadurch gelöst, dass die Baugruppe nach einem Verlöten in einen Reaktor oder eine Kammer gebracht wird, der Reaktor oder die Kammer evakuiert wird und die Baugruppe durch chemische Dampfabscheidung (CVD) mit einer Parylenebeschichtung versehen wird.

Nach dem Verlöten der Bauelemente kann die Baugruppe zunächst gereinigt werden.

Nach dem Verlöten der Bauelemente bzw. nach dem Reinigen der Baugruppe kann eine oder können mehrere nicht zu beschichtende Stellen der Baugruppe maskiert werden. Bei den maskierten Stellen kann es sich zum Beispiel um Kontaktelemente der Baugruppe handeln, die von außen kontaktierbar bleiben müssen. Die maskierten Stellen können nach der chemischen Dampfabscheidung der Paryleneschicht demaskiert werden.

Alternativ kann man auch solche Stellen, die bei der fertigen Baugruppe nicht beschichtet sein sollen, zunächst beschichten und anschließend mittels eines Laserstrahls von der Parylenebeschichtung befreien.

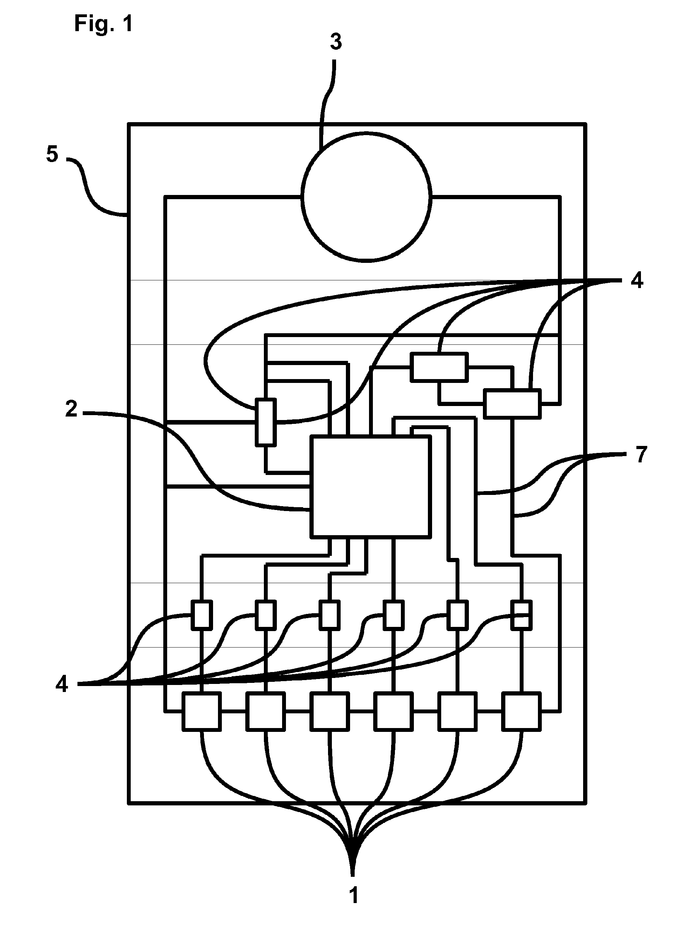

Weitere Merkmale und Vorteile der vorliegenden Erfindung werden deutlich anhand der nachfolgenden Beschreibung eines bevorzugten Ausführungsbeispiels unter Bezugnahme auf die beiliegenden Abbildungen. Es zeigt
- Fig. 1: eine Draufsicht auf eine erfindungsgemäße Baugruppe und

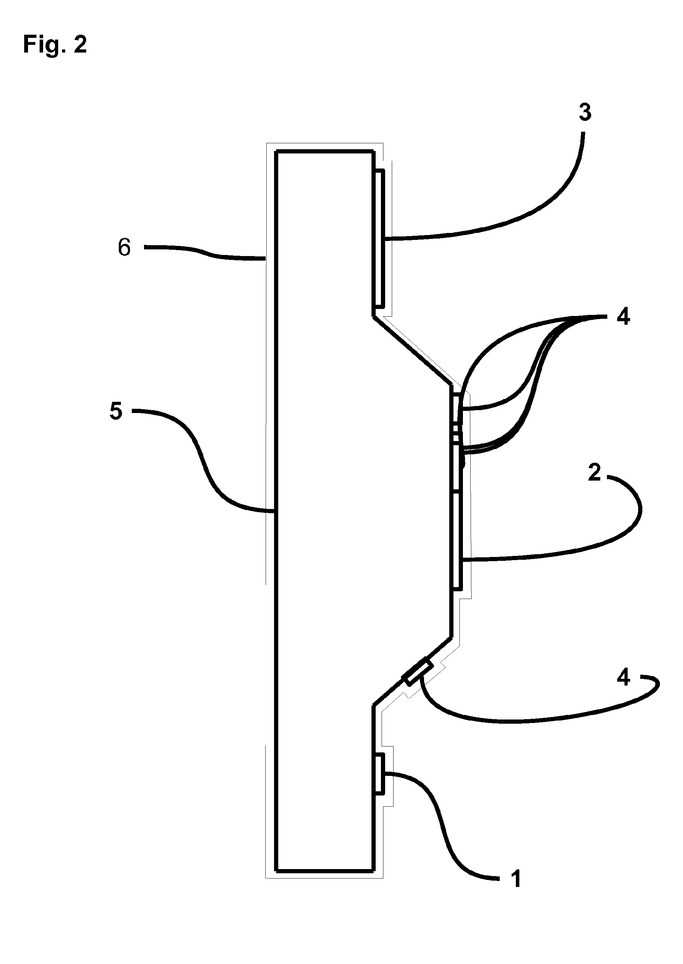

- Fig. 2: eine Seitenansicht der Baugruppe gemäß Fig. 1.

Die in den Figuren dargestellte Baugruppe weist einen Schaltungsträger 5 auf, der eine abgewinkelte Oberfläche hat, auf der eine elektronische Schaltung angeordnet ist. Der Schaltungsträger 5 ist aus einem Kunststoff durch Spritzgießen hergestellt. Anschließend sind auf dem Schaltungsträger 5 Leiterbahnen 7 aufgebracht worden und der Schaltungsträger 5 wurde mit elektronischen Bauelementen bestückt, u. a. mit Leuchtdioden 1 , einem integrierten Schaltkreis 2 und anderen Bauelementen 4. Ferner wurde eine Primärzelle 3 in den Schaltungsträger 5 eingesetzt.

Auf der soweit hergestellten Baugruppe einschließlich der Schaltung und der Primärzelle 3 wurde danach in einer evakuierten Kammer aus einer Gasphase Parylene abgeschieden. Das Parylene hat sich dabei auf der gesamten Oberfläche der Baugruppe abgeschieden und bildet eine Parylenebeschichtung 6, die die Bauelemente 1, 2, 4, die Primärzelle 3, die Leiterbahnen 7 und den Schaltungsträger 5 beschichtet.

## Patentansprüche

1. Elektronische Baugruppe mit einem räumlichen spritzgegossenen Schaltungsträger (5) auf dem elektrische und/oder elektronische Bauelemente (1 , 2, 4) angeordnet sind, **dadurch gekennzeichnet, dass** die Baugruppe eine Parylenebeschichtung (6) aufweist.

2. Baugruppe nach Anspruch 1 , **dadurch gekennzeichnet, dass** die Baugruppe Kontaktelemente aufweist, mit welcher eine durch die Bauelemente (1 , 2, 4) und Leiterbahnen (7) gebildete Schaltung von außen kontaktierbar ist, und dass diese Kontaktelemente zumindest teilweise frei von der Parylenebeschichtung (6) sind.

3. Baugruppe nach Anspruch 1 oder 2, **dadurch gekennzeichnet, dass** die Parylenebeschichtung (6) aus Parylene des Typs C, D, N, F, AF oder HT besteht.

4. Baugruppe nach einem der Ansprüche 1 bis 3, **dadurch gekennzeichnet, dass** die Parylenebeschichtung (6) den Schaltungsträger (5), die Leiterbahnen (7) und die Bauelemente (1, 2, 4) mit Ausnahme der von außen kontaktierbaren Kontaktelemente ganz oder teilweise abdeckt.

5. Baugruppe nach einem der Ansprüche 1 bis 4, **dadurch gekennzeichnet, dass** die Parylenebeschichtung ganz oder teilweise in Spalten oder Ritzen zwischen Bauelementen (1, 2, 4), zwischen Bauelementen (1 , 2, 4) und Schaltungsträgern bzw. zwischen Bauelementen (1, 2, 4) und Leiterbahnen (7) eingedrungen ist.

6. Baugruppe nach einem der Ansprüche 1 bis 5, **dadurch gekennzeichnet, dass** die Parylenebeschichtung an jeder Stelle der Baugruppe oder zumindest an allen ebenen Flächen des Schaltungsträgers und der Bauelemente gleich dick oder nahezu gleich dick ist.

7. Verfahren zum Beschichten einer elektronischen Baugruppe mit einem räumlichen spritzgegossenen elektronischen Schaltungsträger (5), wobei der Schaltungsträger (5) hergestellt, mit Leiterbahnen (7) versehen und mit elektrischen und/oder elektronischen Bauelementen (1 , 2, 4) bestückt wird und die Bauelemente (1 , 2, 4) mit den Leiterbahnen (7) oder miteinander verlötet werden, **dadurch gekennzeichnet, dass** die Baugruppe danach in einen Reaktor oder eine Kammer gebracht wird, der Reaktor oder die Kammer evakuiert wird und die Baugruppe durch chemische Dampfabscheidung mit einer Parylenebeschichtung (6) versehen wird.

8. Verfahren nach Anspruch 7, **dadurch gekennzeichnet, dass** nach dem Verlöten der Bauelemente (1 , 2, 4) die Baugruppe gereinigt wird.

9. Verfahren nach Anspruch 7 oder 8, **dadurch gekennzeichnet, dass** nach dem Verlöten der Bauelemente (1, 2, 4) bzw. nach dem Reinigen der Baugruppe eine oder mehrere nicht zu beschichtende Stellen der Baugruppe maskiert werden.

10. Verfahren nach Anspruch 9, **dadurch gekennzeichnet, dass** die maskierten Stellen nach der chemischen Dampfabscheidung der Parylenebeschichtung (6) demaskiert werden.

11. Verfahren nach Anspruch 7 oder 8, **dadurch gekennzeichnet, dass** nach dem Beschichten Elemente der Baugruppe, zum Beispiel Kontaktelemente, die von außen kontaktierbar sein sollen, mittels eines Laserstrahls von der Parylenebeschichtung (7) befreit werden.
